# EUROPEAN PATENT APPLICATION

(11) **EP 4 644 314 A1**
(43) Date of publication of application: **05.11.2025**
(21) Application number: 23912526.3
(22) Date of filing: 01.11.2023
(51) Int. Cl.: C01B 15/013, B01D 61/42, B01D 61/48, C02F 1/469

(54) **REGENERATING METHOD OF ELECTRODEIONIZATION SYSTEM AND METHOD FOR PURIFYING HYDROGEN PEROXIDE BY USING SAME**

(30) Priority: 29.12.2022 KR 20220189198
(71) Applicant: OCI Company Ltd., Seoul 04532 (KR)
(72) Inventor: UM, Myung Sup, Seongnam-si Gyeonggi-do 13212 (KR); YE, Hee Chang, Seongnam-si Gyeonggi-do 13212 (KR); KIM, Kyung Yeol, Seongnam-si Gyeonggi-do 13212 (KR)
(74) Representative: Marks & Clerk LLP
(86) International application number: PCT/KR2023/017218
(87) International publication number: WO 2024/143846

(57) **Abstract**

The present invention relates to a method for regenerating an electrodeionization system and a method for purifying hydrogen peroxide using the same, and more particularly, to the method including stopping operation of the electrodeionization system used for purification of hydrogen peroxide; performing electrical regeneration while introducing ultrapure water into the electrodeionization system; and restarting the electrodeionization system to perform purification of hydrogen peroxide. The electrical regeneration is performed at a current density of 30 A/m² to 100 A/m².

## Description

### TECHNICAL FIELD

The present invention relates to a method for regenerating an electrodeionization system and a method for purifying hydrogen peroxide using the same, and more particularly, to a method for regenerating an electrodeionization system using ultrapure water electrical regeneration.

### BACKGROUND ART

Hydrogen peroxide has strong oxidation force and decomposition products thereof are harmless. Thus, hydrogen peroxide is used as an oxidization agent, a bleaching agent for silk threads or wool, and a catalyst for vinyl polymerization in the plastics industry. Moreover, hydrogen peroxide is also used for display wafer cleaning or semiconductor wafer cleaning in addition to the above uses.

With the advent of the information age, the field of displays, which visually express electrical information signals, has rapidly advanced. In response, various display devices with excellent properties such as reduced thickness, light weight, and low power consumption are being developed.

A representative example is an organic light emitting diode display device, which involves deposition and patterning processes of various materials on a substrate. In such deposition and patterning processes, conductive members such as metal masks may be used. Due to these deposition and patterning processes, the display substrate may be contaminated with various materials, and therefore, a cleaning process for the display substrate is required. A representative wet cleaning method for the display substrate is a chemical wet cleaning method using hydrogen peroxide.

Techniques for cleaning a semiconductor wafer may be classified into wet cleaning and dry cleaning. A cleaning process is similar to an etching process in that substances on the surface of a semiconductor wafer are removed, but is different therefrom in that impurities present on the surface of a semiconductor wafer are selectively removed. As a representative wet cleaning method, there is a chemical wet method using hydrogen peroxide.

### DISCLOSURE OF THE INVENTION

### TECHNICAL PROBLEM

The present invention provides a method for regenerating an electrodeionization system, the method capable of improving the stability and performance of the electrodeionization system.

The present invention provides a method for purifying hydrogen peroxide, the method capable of producing hydrogen peroxide of high purity.

### TECHNICAL SOLUTION

A method for regenerating an electrodeionization system according to the inventive concept of the present invention may include stopping operation of the electrodeionization system used for purification of hydrogen peroxide; performing electrical regeneration while introducing ultrapure water into the electrodeionization system; and restarting the electrodeionization system to perform purification of hydrogen peroxide. The electrical regeneration may be performed at a current density of 30 A/m² to 100 A/m².

A method for purifying hydrogen peroxide according to another inventive concept of the present invention may include purifying a crude product of hydrogen peroxide with an adsorbent resin of a primary purification system; and purifying a primary purified hydrogen peroxide solution using a secondary purification system. The secondary purification system may comprise an electrodeionization system, and the electrodeionization system may be regenerated according to the above electrical regeneration method.

A method for manufacturing an electronic device according to another inventive concept of the present invention may include performing a cleaning process on a substrate using the hydrogen peroxide purified according to the method for purifying hydrogen peroxide.

### ADVANTAGEOUS EFFECTS

A method for regenerating an electrodeionization system according to the present invention may effectively remove ions and organic carbon from an ion exchange resin. Accordingly, bubble generation caused by the introduction of hydrogen peroxide during the restart of the electrodeionization system can be prevented, the resistance of the electrodeionization system can be reduced, and the performance can be rapidly restored.

### BRIEF DESCRIPTION OF THE DRAWINGS

FIG. 1 is a schematic view for describing a hydrogen peroxide purification system according to embodiments of the present invention.
FIG. 2 is a schematic view for describing an electrodeionization system of the hydrogen peroxide purification system of FIG. 1.
FIG. 3 is a flowchart for describing an electrical regeneration process of an electrodeionization system according to embodiments of the present invention.
FIG. 4 is a schematic view of an electrodeionization system for describing the electrical regeneration process of FIG. 3.
FIG. 5 is a schematic view for describing a hydrogen peroxide purification system according to embodiments of the present invention.
FIG. 6 is a schematic view for describing a cleaning process of a substrate using purified hydrogen peroxide according to embodiments of the present invention.

### MODE FOR CARRYING OUT THE INVENTION

In order to facilitate sufficient understanding of the configuration and effects of the present invention, preferred embodiments of the present invention will be described with reference to the accompanying drawings. However, the present invention is not limited to the embodiments set forth below, and may be embodied in various forms and modified in many alternate forms. Rather, these embodiments are provided so that this disclosure will be thorough and complete, and will fully convey the scope of the present invention to those skilled in the art to which the present invention pertains.

In the present description, when an element is referred to as being on another element, it means that the element may be directly formed on another element, or that a third element may be interposed therebetween. Also, in the drawings, the thicknesses of elements are exaggerated for an effective description of technical contents. Like reference numerals refer to like elements throughout the specification.

Although the terms such as first, second, third, and the like are used to describe various elements in various embodiments of the present description, these elements should not be limited by these terms. These terms are only used to distinguish one element from another. The embodiments described and exemplified herein also include the complementary embodiments thereof.

The terms used herein are for the purpose of describing embodiments and are not intended to be limiting of the present invention. In the present description, singular forms include plural forms unless the context clearly indicates otherwise. As used herein, the terms 'comprises' and/or 'comprising' are intended to be inclusive of the stated elements, and do not exclude the possibility of the presence or the addition of one or more other elements.

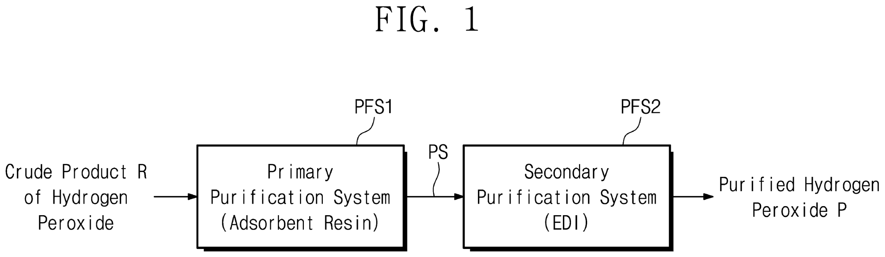

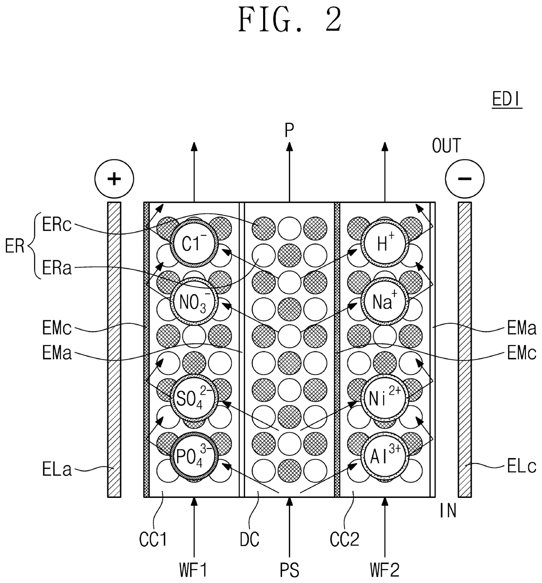

FIG. 1 is a schematic view for describing a hydrogen peroxide purification system according to embodiments of the present invention. FIG. 2 is a schematic view for describing an electrodeionization system of the hydrogen peroxide purification system of FIG. 1.

Referring to FIG. 1 and FIG. 2, the hydrogen peroxide purification system may include a primary purification system PFS1 and a secondary purification system PFS2. A crude product R of hydrogen peroxide is purified sequentially through the primary purification system PFS1 and the secondary purification system PFS2, and purified hydrogen peroxide P may be finally obtained from the crude product R of hydrogen peroxide.

The crude product R of hydrogen peroxide may be produced by an alkyl anthraquinone process. The crude product R of hydrogen peroxide may be a product synthesized by an alkyl anthraquinone hydrogenation-oxygenation reaction. The crude product R of hydrogen peroxide may be a product of an alkyl anthraquinone process which has not been subjected to a purification process such as distillation.

Specifically, when hydrogen is added to alkyl anthraquinone to produce hydroquinone and then the hydroquinone is reacted with oxygen in the air, the hydroquinone is reduced back to anthraquinone, which may produce hydrogen peroxide. The crude product R of hydrogen peroxide may be extracted and obtained by adding water to anthraquinone, which is a product of an oxidation reaction, and hydrogen peroxide.

The crude product R of hydrogen peroxide generated by the alkyl anthraquinone process may include cation impurities (or metal impurities) such as Al, Ni and Cr having a concentration of 100 ppb or greater, anion impurities such as PO₄³⁻, SO₄²⁻, NO₃⁻, and Cl⁻ having a concentration of 100 ppb or greater, and a total organic carbon (TOC) having a concentration of 100 ppm or greater.

The crude product R of hydrogen peroxide may be introduced into a primary purification system PFS1. The primary purification system PFS1 according to an embodiment of the present invention may be a resin system.

The resin system according to the present invention may include an adsorbent resin composed of a porous polymer. The resin system may remove organic carbon from the crude product R of hydrogen peroxide via an adsorption filter filled with the adsorbent resin. The adsorbent resin according to the embodiment of the present invention may remove not only organic carbon but also cations from the crude product R of hydrogen peroxide.

The adsorbent resin according to embodiments of the present invention may include porous polymer particles. The specific surface area of the adsorbent resin may range from 300 m² /g to 1,000 m² /g. More specifically, the specific surface area of the adsorbent resin may range from 300 m² /g to 800 m\²/g.

The average pore size (or diameter) of the adsorbent resin may range from 10 Å to 200 Å. More specifically, the average pore size of the adsorbent resin may range from 40 Å to 100 Å. The pore volume of the adsorbent resin may range from 0.5 mL/g to 2 mL/g. The average particle diameter of the adsorbent resin may range from 0.3 mm to 2 mm.

The adsorbent resin according to the present invention may be a non-polar (or neutral) that does not carry electric charge. In one embodiment of the present invention, the adsorbent resin may include a hydrophobic polymer. The polymer of the adsorbent resin may have a hydrophobic group. For example, the hydrophobic group may include an alkyl group having 1 to 20 carbon atoms. The adsorbent resin according to the present invention may be a hydrophobic adsorbent resin that does not have an ion exchange group.

The polymer of the adsorbent resin may comprise a polyaromatic compound. More specifically, the polymer of the adsorbent resin may include an aromatic polymer to which a hydrophobic group is bonded. For example, the polymer of the adsorbent resin may include at least one selected from the group consisting of styrene/divinylbenzene copolymer, styrene/trivinylbenzene copolymer, and vinyltoluene/divinylbenzene copolymer. Preferably, hydrophobic group may be bonded to the copolymer.

The adsorbent resin according to the present invention may be a non-polar resin that does not carry a charge. In one embodiment of the present invention, an ion exchange resin having cationic/anionic functional group may be excluded from the adsorbent resin of the present invention. The adsorbent resin according to the present invention described above may adsorb and remove not only organic carbon but also ions in the crude product R of hydrogen peroxide.

Impurities in the crude product R of hydrogen peroxide may be partially removed through a primary purification system PFS1, and a primary purified hydrogen peroxide solution PS may be obtained. The concentration of TOC in the primary purified hydrogen peroxide solution PS may be reduced to 100 ppm or less by the adsorbent resin, which serves as the primary purification system PFS1. The concentration of ions in the primary purified hydrogen peroxide solution PS may be reduced by the adsorbent resin, which serves as the primary purification system PFS1.

In another embodiment of the present invention, the adsorbent resin in the primary purification system PFS1 may further comprise an ionic resin in addition to a neutral resin. In other words, the adsorbent resin of the present invention may be a mixture of the neutral resin and the ionic resin. Through the ionic resin, ions may be more effectively removed in the primary purification system PFS1.

Cations in the crude product R of hydrogen peroxide may be adsorbed onto the adsorbent resin of the primary purification system PFS1, so that the concentration of cations in the primary purified hydrogen peroxide solution PS may be lower than the concentration of cations in the crude product R of hydrogen peroxide.

The primary purified hydrogen peroxide solution PS may be introduced into the secondary purification system PFS2. The secondary purification system PFS2 may include an electrodeionization system EDI. An electrodeionization process may be performed on the hydrogen peroxide solution PS using the electrodeionization system EDI.

Referring back to FIG. 2, the electrodeionization system EDI may include a first electrode ELa, a second electrode ELc, a first concentrate chamber CC1, a second concentrate chamber CC2, and a dilute chamber DC between the first and second concentrate chambers CC1 and CC2. The first and second concentrate chambers CC1 and CC2, and the dilute chamber DC may be interposed between the first and second electrodes ELa and ELc. For example, the first electrode ELa may be an anode, and the second electrode ELc may be a cathode.

Anion exchange membranes EMa and cation exchange membranes EMc may be alternately disposed between the first and second electrodes ELa and ELc. For example, an anion exchange membrane EMa may be interposed between the first concentrate chamber CC1 and the dilute chamber DC, and between the second concentrate chamber CC2 and the second electrode ELc, respectively. A cation exchange membrane EMc may be interposed between the second concentrate chamber CC2 and the dilute chamber DC, and between the first concentrate chamber CC1 and the first electrode ELa, respectively. The anion exchange membrane EMa may transmit anions, but not cations. The cation exchange membrane EMc may transmit cations, but not anions.

An ion exchange resin ER may be provided in the dilute chamber DC. In an embodiment of the present invention, the ion exchange resin ER may also be provided in the first concentrate chamber CC1 and the second concentrate chamber CC2. In particular, when the ion exchange resin ER is also provided in the first concentrate chamber CC1 and the second concentrate chamber CC2, the hydrogen peroxide purification efficiency may further be improved. The ion exchange resin ER may include an anion exchange resin ERa and a cation exchange resin ERc. The anion exchange resin ERa may adsorb anions, and move the anions to the anion exchange membrane EMa. The cation exchange resin ERc may adsorb cations, and move the cations to the cation exchange membrane EMc. For example, the ion exchange resin ER may prevent the resistance of the hydrogen peroxide solution PS from increasing even when the concentration of ions in the hydrogen peroxide solution PS decreases.

The hydrogen peroxide solution PS and water may be introduced into an inlet IN of the electrodeionization system EDI. The water may be purified water having low electrical conductivity. The concentration of hydrogen peroxide in the hydrogen peroxide solution PS to be introduced may be 1 wt% to 70 wt%. The hydrogen peroxide solution PS may be introduced into the dilute chamber DC, and the water may be introduced into the first concentrate chamber CC1 and the second concentrate chamber CC2. The concentration of hydrogen peroxide in a first concentrate WF1 to be introduced into the first concentrate chamber CC1 and the concentration of a second concentrate WF2 to be introduced into the second concentrate chamber CC2 may be 1 wt% or less.

Direct current power may be applied between the first and second electrodes, ELa and ELc, to allow a current to flow from the first electrode ELa to the second electrode ELc. Cations (e.g., metal impurities) of the hydrogen peroxide solution PS in the dilute chamber DC may pass through the cation exchange membrane EMc by electrostatic attraction generated through the direct current power and move to the second concentrate WF2 of the second concentrate chamber CC2. Anions (e.g., anion impurities) of the hydrogen peroxide solution PS in the dilute chamber DC may pass through the anion exchange membrane EMa by electrostatic attraction generated through the direct current power and move to the first concentrate WF1 of the first concentrate chamber CC1.

The concentration of ions in the hydrogen peroxide solution PS may decrease from the inlet IN of the dilute chamber DC to an outlet OUT thereof. In other words, the concentration of impurities in the hydrogen peroxide solution PS may decrease from the inlet IN of the dilute chamber DC to the outlet OUT thereof. The purified hydrogen peroxide P may be discharged through the outlet OUT of the dilute chamber DC.

The first concentrate WF1 and the second concentrate WF2 may be discharged through the outlet OUT of each of the first and second concentrate chambers CC1 and CC2. The discharged first concentrate WF1 and second concentrate WF2 may have impurities concentrated therein, which are transferred from the hydrogen peroxide solution PS. For example, the discharged first concentrate WF1 and second concentrate WF2 may be discarded. For another example, the first concentrate WF1 and the second concentrate WF2 may be filtered and reintroduced into the inlet IN of the electrodeionization system EDI. That is, the first concentrate WF1 and the second concentrate WF2 may be circulated in the electrodeionization system EDI.

Since the concentration of the ions in the hydrogen peroxide solution PS decreases from the inlet IN of the dilute chamber DC to the outlet OUT thereof, in one region of the dilute chamber DC adjacent to the outlet OUT, the resistance of the hydrogen peroxide solution PS may increase. As a result, in the one region of the dilute chamber DC, a voltage drop may occur, so that decomposition of water and/or decomposition of hydrogen peroxide may occur. Hydrogen ions and hydroxide ions may be produced by the decomposition of water and/or the decomposition of hydrogen peroxide, and the produced hydrogen ions and hydroxide ions may regenerate the ion exchange resin ER. Therefore, the electrodeionization system EDI according to the present invention may not require a separate process for regenerating the ion exchange resin ER.

The hydrogen peroxide purification system according to embodiments of the present invention uses the electrodeionization system EDI as the secondary purification system PFS2 for hydrogen peroxide, so that hydrogen peroxide of high purity may be obtained to a high yield. Furthermore, the electrodeionization system EDI can be operated at a relatively high flow rate, and for example it may be operated at about 0.1 to 10 m³/hr per electrodeionization stack. The amount of production can be adjusted depending on the system design (e.g., stack area, number of cells, and number of stacks), thereby ultimately enabling the mass production of high-purity hydrogen peroxide.

It was confirmed that when the stability of the hydrogen peroxide solution PS introduced into the electrodeionization system EDI is lower than the reference value, the purification performance and stability of the electrodeionization system EDI rapidly decrease over the operation time. It was also confirmed that when the stability of the hydrogen peroxide solution PS is lower than the above reference value, the removal rates of ions and organic carbon by the electrodeionization system EDI also decrease rapidly over the operation time.

The stability may be measured by a hydrogen peroxide stability measurement method (Standard No.: KSM1112) defined in the National Standard Certification Integrated Information System (KS standard). According to embodiments of the present invention, the reference value of the stability may be 90%. More specifically, the reference value may be 95%. If the stability of the hydrogen peroxide solution PS is less than 90%, the economic performance and durability according to the operation time of the electrodeionization system EDI may be rapidly degraded. On the other hand, if the stability of the hydrogen peroxide solution PS is greater than 90%, the impurity removal rate according to the operation time of the electrodeionization system EDI may be stably maintained and the durability may be improved.

According to embodiments of the present invention, the adsorbent resin, which serves as the primary purification system PFS1 is capable of removing not only organic carbon in the crude product R of hydrogen peroxide but also ions (e.g., cations). As a result, the stability of the hydrogen peroxide solution PS introduced into the electrodeionization system EDI may be improved. When the stability of the hydrogen peroxide solution PS is equal to or higher than the above reference value, the purification performance and stability of the electrodeionization system EDI over the operation time can be maintained in a favorable state, and the removal rates of impurities (e.g., ions and organic carbon) can also be favorably maintained.

According to embodiments of the present invention, organic carbon and cations in the crude product R of hydrogen peroxide can be simultaneously removed using only the adsorbent resin process, which serves as the primary purification system PFS1. As a comparative example of the present invention, if an additional purification system (e.g., an ion exchange resin system or a reverse osmosis system) is used prior to the introduction into the electrodeionization system EDI, the economic efficiency of the hydrogen peroxide purification process may be significantly reduced.

As another comparative example of the present invention, when the adsorbent resin process, which serves as the primary purification system PFS1, is omitted and the crude product R of hydrogen peroxide is directly introduced into the electrodeionization system EDI, a problem may occur in which the performance and stability of the electrodeionization system EDI are significantly reduced.

The present invention may improve the performance and stability of the electrodeionization system EDI through only a simple pretreatment process (namely, the adsorbent resin process serving as the primary purification system PFS1).

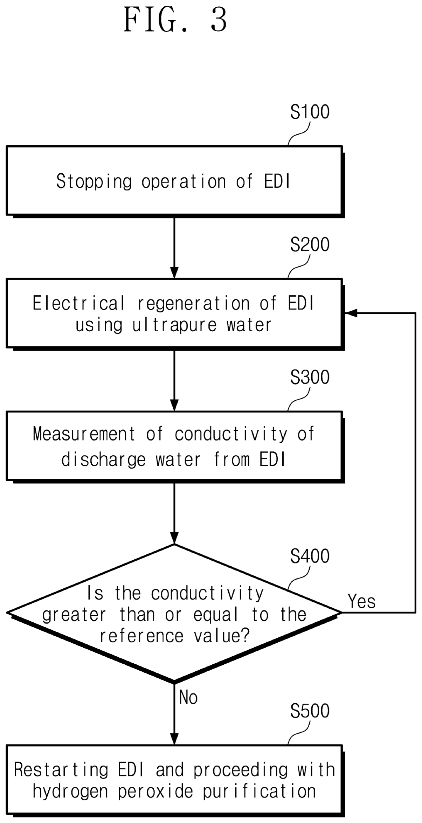

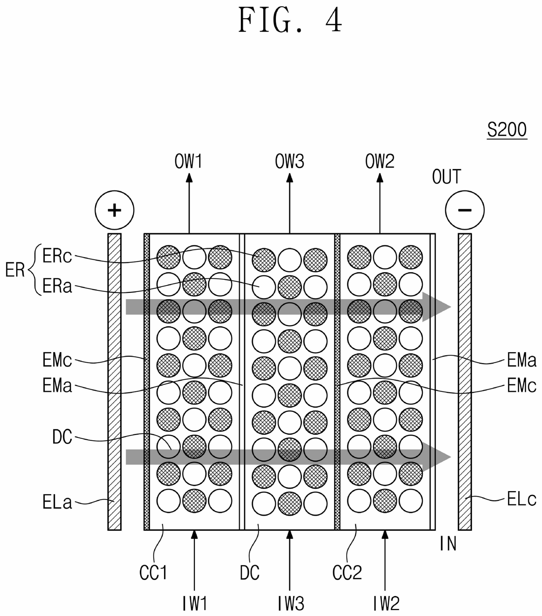

FIG. 3 is a flowchart for describing an electrical regeneration process of an electrodeionization system according to embodiments of the present invention. FIG. 4 is a schematic view of an electrodeionization system for describing the electrical regeneration process of FIG. 3.

Referring to FIG. 3, the operation of the above-described electrodeionization system EDI may be stopped (S100). For example, the operation of the electrodeionization system EDI may be stopped to replace a module of the electrodeionization system EDI or for maintenance of the electrodeionization system EDI. The operation of the electrodeionization system EDI may also be stopped for maintenance of the primary purification system PFS1.

In the case of an electrodeionization system EDI used in a hydrogen peroxide purification process, a regeneration process for the electrodeionization system EDI may be performed before restarting the operation after the operation has been stopped. In particular, in order to improve the purification efficiency of hydrogen peroxide, it may be desirable to carry out the regeneration process before restarting the electrodeionization system EDI.

Referring to FIG. 4, regenerating the electrodeionization system EDI may include introducing ultrapure water (e.g., deionized water) into the first and second concentrate chambers CC1, CC2 and the dilute chamber DC to wash the inside of the electrodeionization system EDI.

Specifically, a first feed water IW1 may be introduced into the first concentrate chamber CC1 and may be discharged as a first discharge water OW1. A second feed water IW2 may be introduced into the second concentrate chamber CC2 and may be discharged as a second discharge water OW2. A third feed water IW3 may be introduced into the dilute chamber DC and may be discharged as a third discharge water OW3. Each of the first feed water IW1, the second feed water IW2, and the third feed water IW3 may be ultrapure water (e.g., deionized water).

Meanwhile, in order to regenerate the electrodeionization system EDI, there is a method in which the first to third feed waters IW1, IW2 and IW3 are simply introduced into the electrodeionization system EDI. Although this method is suitable as a regeneration method for an electrodeionization system EDI used for water purification, it has been confirmed that it is inappropriate for the electrodeionization system EDI used for purifying hydrogen peroxide according to the present invention. When the electrodeionization system EDI is regenerated using only the first to third feed waters IW1, IW2 and IW3, it has been confirmed that the stability upon restarting the electrodeionization system EDI decreases and that it takes a long time for the performance to recover.

On the other hand, according to embodiments of the present invention, not only by introducing the first to third feed waters IW1, IW2 and IW3, but also by additionally performing electrical regeneration by applying a current to the electrodeionization system EDI, the stability of the electrodeionization system EDI upon restarting may be improved, and rapid recovery of performance may be enabled.

Referring back to FIG. 4, in an electrical regeneration method (S200) of the electrodeionization system EDI according to the present invention, the first to third feed waters IW1, IW2 and IW3 may be introduced into the first concentrate chamber CC1, the second concentrate chamber CC2, and the dilute chamber DC, respectively, and a voltage may be applied to a first electrode ELa and a second electrode ELc at the same time. As a result, a current DC may flow from the first electrode ELa to the second electrode ELc. The current DC may be direct current.

In an embodiment of the present invention, the current DC during the electrical regeneration may be equal to or greater than the current flowing from the first electrode ELa to the second electrode ELc during hydrogen peroxide purification of FIG. 2. The magnitude of the current DC according to the present invention may vary depending on the size of the electrodeionization system EDI. The current density during the electrical regeneration according to the present invention may be from 10 A/m ² to 100 A/m². More specifically, the current density during the electrical regeneration may be from 30 A/m ² to 100 A/m ².

If the current density is lower than 30 A/m ², ion resin regeneration may not be sufficiently performed. If the current density is greater than 100 A/m ², problems such as side reactions and degradation of the materials of the electrodeionization system EDI may occur.

The electrical regeneration may be performed for 1 hour to 24 hours, more specifically 1 hour to 3 hours. The flow rates of the first to third feed waters IW1, IW2 and IW3 may be appropriately selected by the user in accordance with the equipment guidelines of the electrodeionization system EDI. For example, the flow rate of the first to third feed waters IW1, IW2 and IW3 may be substantially the same as the flow rate of each of the first concentrate WF1, the second concentrate WF2, and the hydrogen peroxide solution PS, respectively, in FIG. 2. In an embodiment of the present disclosure, the flow rate of the first feed water IW1 may be the same as that of the second feed water IW2. The flow rate of the first feed water IW1 may be smaller than the flow rate of the third feed water IW3.

Through the electrical regeneration of the electrodeionization system EDI according to the present invention, the ion exchange resin ER in the electrodeionization system EDI can be regenerated. Impurities in the ion exchange resin ER of the electrodeionization system EDI may be effectively removed through the electrical regeneration. In particular, ions and organic carbon in the ion exchange resin ER can be effectively removed by the electrical regeneration.

Referring back to FIG. 3, the conductivity of the third discharge water OW3 discharged from the dilute chamber DC of the electrodeionization system EDI after the electrical regeneration of the electrodeionization system EDI can be measured (S300). By measuring the conductivity of the third discharge water OW3, it can be confirmed whether organic carbon and ions (e.g., cations and anions) in the ion exchange resin ER have been removed to a level that satisfies the reference value (S400).

When the conductivity of the third discharge water OW3 is equal to or greater than the reference value, it can be determined that the ion exchange resin ER has not been sufficiently regenerated. In this case, the electrical regeneration of the electrodeionization system EDI (S200) may be performed again for the stability of the electrodeionization system EDI.

In one embodiment of the present invention, the ion exchange resin ER may be reused via electrical regeneration (S200), but may also be replaced at a predetermined cycle (e.g., 6 months).

When the conductivity of the third discharge water OW3 is less than the reference value, it can be determined that the ion exchange resin ER has been regenerated to a desired level. In this case, the stability of the electrodeionization system EDI is ensured, and the electrodeionization system EDI can be restarted for hydrogen peroxide purification (S500).

The reference value of the conductivity of the third discharge water OW3 may be defined based on a case in which stable operation is possible when the electrodeionization system EDI is restarted. When the electrodeionization system EDI is restarted, the conditions under which the decomposition reaction of hydrogen peroxide in the electrodeionization system EDI is minimized and the problem of channeling occurring is eliminated can be defined as the reference value of the conductivity. The reference value of the conductivity may be defined as a value between 5.0 µS/m and 20.0 µS/m. More specifically, the reference value of the conductivity may be defined as a value between 5.0 µS/m and 10.0 µS/m. For example, when the reference value of the conductivity is set to 20.0 µS/m, if the conductivity of the third discharge water OW3 is measured to be less than 20.0 µS/m, it can be determined that the ion exchange resin ER has been regenerated to a desired level.

### Experimental Example 1

The electrodeionization system was stopped, and electrical regeneration, as described with reference to FIGS. 3 and 4, was performed. Specifically, a current of 77 A/m² was applied for 2 hours and 30 minutes while ultrapure water (deionized water) was introduced into the concentrate chamber and the dilute chamber of the electrodeionization system. The conductivity of the discharge water discharged from the dilute chamber was then measured to be 6.3 µS/m. After the electrical regeneration of the electrodeionization system, the system was restarted to determine the removal rate of cations in the hydrogen peroxide (Example 1).

The electrodeionization system was stopped, and regeneration was performed by washing the electrodeionization system described above with ultrapure water. That is, the washing was carried out by introducing only ultrapure water into the concentrate chamber and the dilute chamber without applying a separate current to the electrodeionization system. The conductivity of the discharge water discharged from the dilute chamber after washing regeneration was measured to be 13 µS/m. After the washing regeneration of the electrodeionization system, the system was restarted to determine the removal rate of cations in hydrogen peroxide (Comparative Example 1).

The results of Example 1 and Comparative Example 1 are shown in Table 1 below.

**[Table 1]**

| Removal Rate (%) | Hydrogen Peroxide Purification After Ultrapure Water Washing (Comparative Example 1) | | | Hydrogen Peroxide Purification After Ultrapure Water Electrical Regeneration (Example 1) | | |
|---|---|---|---|---|---|---|
| | before stoppage | 1 day after restart | 6 days after restart | before stoppage | 1 day after restart | 4 days after restart |
| Na | 99 | 91 | 98 | 99 | 96 | 97 |
| Al | 96 | 62 | 93 | 99 | 97 | 99 |
| K | 98 | 85 | 98 | 99 | 98 | 99 |
| Ca | 97 | 83 | 95 | 70 | 90 | 95 |
| Fe | 96 | 81 | 88 | 84 | 91 | 95 |
| Ni | 90 | 47 | 84 | 91 | 84 | 91 |
| Zn | 87 | 51 | 84 | 95 | 92 | 96 |

In Comparative Example 1, it was confirmed that the cation removal rates for cations such as Al, K, Ca, Fe, Ni and Zn were significantly reduced on Day 1 after restarting the electrodeionization system. This is because, after the electrodeionization system was restarted, a decomposition reaction of hydrogen peroxide occurred due to ions adsorbed on the EDI ion exchange resin, resulting in performance degradation, such as bubble generation. Although the cation removal rates recovered to some extent by Day 6 after the restart, it was confirmed that more than one week was required to restore the performance to the level prior to the suspension of operation. The longer the operating period of the EDI, the more time it may take for the performance to recover. On the other hand, in Example 1, it can be confirmed that the cation removal rates for cations such as Al, K, Ca, Fe, Ni and Zn did not drop significantly on Day 1 after restarting the electrodeionization system, compared to the state before suspension. Furthermore, it was confirmed that the performance of the electrodeionization system had been fully restored on Day 4 after restarting.

That is, the ultrapure water electrical regeneration of the electrodeionization system according to the present invention can prevent bubble generation caused by the introduction of hydrogen peroxide when the electrodeionization system is restarted, and can rapidly restore the performance of the electrodeionization system.

### Experimental Example 2

Purification of hydrogen peroxide was performed using an electrodeionization system, and the concentrations of cations and anions of the purified hydrogen peroxide discharged from the dilute chamber were measured. The electrodeionization system was stopped, and electrical regeneration, as described with reference to FIGS. 3 and 4, was performed. Specifically, a current of 73 A/m² was applied for 3 hours while ultrapure water (deionized water) was introduced into the concentrate chamber and the dilute chamber of the electrodeionization system. After the electrical regeneration of the electrodeionization system, the system was restarted and the concentrations of cations and anions of the purified hydrogen peroxide discharged from the dilute chamber were measured (Example 2).

Purification of hydrogen peroxide was performed using an electrodeionization system, and the concentrations of cations and anions of the purified hydrogen peroxide discharged from the dilute chamber were measured. The electrodeionization system was stopped, and electrical regeneration, as described with reference to FIGS. 3 and 4, was performed. Specifically, a current of 20 A/m² was applied for 3 hours while ultrapure water (deionized water) was introduced into the concentrate chamber and the dilute chamber of the electrodeionization system. After the electrical regeneration of the electrodeionization system, the system was restarted and the concentrations of cations and anions of the purified hydrogen peroxide discharged from the dilute chamber were measured (Comparative Example 2).

The results of Example 2 and Comparative Example 2 are shown in Table 2 below.

**[Table 2]**

| Ion (ppt) | Comparative Example 2 | | | Example 2 | | |
|---|---|---|---|---|---|---|
| | Day 18 of Purification Just Before Electrical Regeneration | After 20 A/m² 3 hr Electrical Regeneration Day 19 of Purification | Change rate(%) | Day 21 of Purification Just Before Electrical Regeneration | After 73 A/m² 3 hr Electrical Regeneration Day 22 of Purification | Change rate(%) |
| Na | 3,175 | 2,986 | -6 | 2,551 | 1,621 | -36 |
| K | 210 | 247 | +18 | 201 | 191 | -5 |
| Cr | 30 | 60 | +100 | 62 | 45 | -27 |
| Ni | 548 | 925 | +69 | 1,057 | 683 | -35 |
| Zn | 47 | 56 | +19 | 56 | 44 | -21 |
| PO4 (ppb) | 19 | 22 | +16 | 25 | 26 | +4 |

In Comparative Example 2, when comparing before and after the electrical regeneration, it was confirmed that the concentrations of cations (Na, K, Cr, Ni and Zn) in the purified hydrogen peroxide were similar or higher. That is, when the electrical regeneration was performed on the electrodeionization system at a current density lower than 30 A/m², it was confirmed that the concentrations of cations and anions were similar to or slightly higher than those before the regeneration. This indicates that the current density in the electrical regeneration according to Comparative Example 2 may not have been sufficient for the regeneration of the ionic resin. In Example 2, when comparing before and after the electrical regeneration, it was confirmed that the concentrations of cations (Na, K, Cr, Ni, and Zn) in the purified hydrogen peroxide significantly decreased. That is, when the electrical regeneration was performed on the electrodeionization system at a current density of 30 A/m² to 100 A/m², it was confirmed that the concentrations of the cations and anions in the hydrogen peroxide after regeneration were similar to or significantly lower than those before regeneration. Through this, it was confirmed that the electrical regeneration at the current density of Example 2 was sufficiently performed.

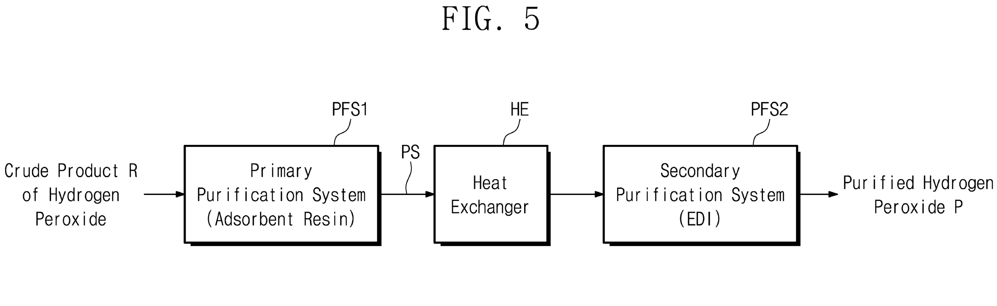

FIG. 5 is a schematic view for describing a hydrogen peroxide purification system according to embodiments of the present invention. Referring to FIG. 5, the hydrogen peroxide purification system may further include a heat exchanger HE disposed between the first purification system PFS1 and the secondary purification system PFS2. When the primarily purified hydrogen peroxide solution PS passes through the heat exchanger HE, the temperature thereof may be adjusted. The heat exchanger HE may adjust the temperature of the hydrogen peroxide solution PS to between -20°C to 20°C. In other words, the hydrogen peroxide solution PS having a temperature of -20°C to 20°C may be introduced into the electrodeionization system EDI, which is the secondary purification system PFS2.

Since hydrogen peroxide is a strong oxidization agent, hydrogen peroxide may oxidize and age an ion exchange medium in the dilute chamber DC of the electrodeionization system EDI. Accordingly, the pressure inside the electrodeionization EDI system may increase due to the oxygen generated by the decomposition of hydrogen peroxide through side reactions in the dilute chamber. As the temperature of hydrogen peroxide increases, the amount of oxygen generated may rapidly increase. If oxygen is excessively generated, the pressure in the electrodeionization system EDI may increase excessively, so that the electrodeionization system EDI may be damaged and the efficiency of a purification process may be decreased.

According to the present embodiment, the temperature of the hydrogen peroxide solution PS to be introduced into the electrodeionization system EDI may be appropriately adjusted through the heat exchanger HE to prevent oxygen from being excessively generated. The heat exchanger HE can further improve the stability of the hydrogen peroxide solution PS according to the present invention. As a result, damage to the electrodeionization system EDI may be prevented and purification efficiency of hydrogen peroxide may be increased.

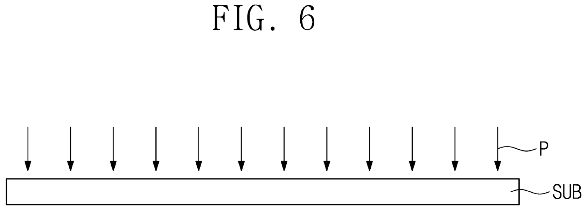

Through the method for purifying hydrogen peroxide according to the above-described embodiments of the present invention, hydrogen peroxide of high purity may be obtained. FIG. 6 is a schematic view for describing a process of cleaning a substrate using hydrogen peroxide purified according to embodiments of the present invention.

Referring to FIG. 6, the method of manufacturing an electronic device may include a process of cleaning a substrate SUB. The substrate SUB according to embodiments of the present invention may comprise a display substrate or a semiconductor substrate. Specifically, the process of cleaning the substrate SUB may include applying the hydrogen peroxide P purified by the purification method of the present invention onto the substrate SUB. As an example, the display substrate may include a substrate for an organic light emitting display device, a substrate for a micro-LED display device, or an LCD substrate. The semiconductor substrate SUB may include silicon, germanium, or silicon-germanium.

If hydrogen peroxide containing impurities is used in the cleaning process, the impurities may react with substances on the substrate SUB and cause defects in the process. Meanwhile, the purified hydrogen peroxide P according to the present invention has a very low impurity content, so that defects in the process may be prevented.

Although the present invention has been described with reference to the accompanying drawings, it will be understood by those having ordinary skill in the art to which the present invention pertains that various changes in form and details may be made therein without departing from the spirit and scope of the present invention. Therefore, it is to be understood that the above-described embodiments are exemplary and non-limiting in every respect.

## Claims

1. A method for regenerating an electrodeionization system, comprising:
stopping operation of the electrodeionization system used for purification of hydrogen peroxide;
performing electrical regeneration while introducing ultrapure water into the electrodeionization system; and
restarting the electrodeionization system to perform purification of hydrogen peroxide,
wherein the electrical regeneration is performed at a current density of 30 A/m² to 100 A/m².

2. The method of claim 1,
wherein the electrical regeneration is performed for 1 hour to 24 hours.

3. The method of claim 1, further comprising measuring a conductivity of discharge water from the electrodeionization system,
restarting the electrodeionization system when the conductivity is lower than a reference value,
wherein the reference value is defined as a value between 5.0 µS/m and 20.0 µS/m.

4. The method of claim 1,
wherein the electrodeionization system comprises:
a first electrode and a second electrode;
a first concentrate chamber, a second concentrate chamber and a dilute chamber between the first and second concentrate chambers;
an ion exchange resin provided inside the dilute chamber, the first concentrate chamber, and the second concentrate chamber;
an anion exchange membrane between the first concentrate chamber and the dilute chamber; and
a cation exchange membrane between the second concentrate chamber and the dilute chamber.

5. The method of claim 4,
wherein introducing the ultrapure water into the electrodeionization system comprises:
introducing a first feed water into the first concentrate chamber;
introducing a second feed water into the second concentrate chamber; and
introducing a third feed water into the dilute chamber.

6. The method of claim 4,
wherein performing the electrical regeneration comprises passing a current from the first electrode to the second electrode.

7. The method of claim 4,
wherein performing the electrical regeneration comprises removing ions from the ion exchange resin.

8. A method for purifying hydrogen peroxide, comprising:
purifying a crude product of hydrogen peroxide with an adsorbent resin of a primary purification system; and
purifying a primary purified hydrogen peroxide solution using a secondary purification system,
wherein the secondary purification system comprises an electrodeionization system, and
wherein the electrodeionization system is regenerated according to the method of claim 1.

9. The method of claim 8,
wherein the adsorbent resin comprises a hydrophobic aromatic polymer.

10. The method of claim 8,
wherein the adsorbent resin comprises a neutral resin and an ionic resin.

11. The method of claim 8, further comprising passing the primary purified hydrogen peroxide solution through a heat exchanger.

12. A method for manufacturing an electronic device, comprising:
performing a cleaning process on a substrate using the hydrogen peroxide purified according to claim 1.
